(19) **Europäisches Patentamt**

**European Patent Office**

**Office européen des brevets**

(11) **EP 0 946 925 B1**

(12) **FASCICULE DE BREVET EUROPEEN**

(45) Date de publication et mention
de la délivrance du brevet:
**18.07.2001 Bulletin 2001/29**

(51) Int Cl.⁷: **G06K 11/16**

(21) Numéro de dépôt: **97952959.1**

(22) Date de dépôt: **19.12.1997**

(86) Numéro de dépôt international:
**PCT/FR97/02366**

(87) Numéro de publication internationale:
**WO 98/28708 (02.07.1998 Gazette 1998/26)**

(54) **PROCEDE D'OPTIMISATION DE LA DETECTION DU POINT D'ATTOUCHEMENT D'UNE SURFACE TACTILE CAPACITIVE**

VERFAHREN ZUR OPTIMIERUNG DER BERÜHRPUNKTSERKENNUNG EINES KAPAZITIVEN
BERÜHRUNGSSENSORS

METHOD FOR OPTIMISING THE DETECTION OF THE CONTACT POINT OF A TACTILE
CAPACITANCE SURFACE

(84) Etats contractants désignés:
**BE DE GB IT SE**

(30) Priorité: **20.12.1996 FR 9615744**

(43) Date de publication de la demande:
**06.10.1999 Bulletin 1999/40**

(73) Titulaire: **THALES AVIONICS S.A.**
**78141 Vélizy Villacoublay Cédex (FR)**

(72) Inventeurs:
• **CONI, Philippe Thomson-CSF S.C.P.I.**
**F-94117 Arcueil Cedex (FR)**
• **FAGARD, Pierre Thomson-CSF S.C.P.I.**
**F-94117 Arcueil Cedex (FR)**

(74) Mandataire: **Chaverneff, Vladimir**
**Thomson-CSF Propriété Intellectuelle,**
**13, Avenue du Président Salvador Allende**
**94117 Arcueil Cédex (FR)**

(56) Documents cités:
**EP-A- 0 733 990          GB-A- 2 205 164**

## Description

La présente invention se rapporte à un procédé d'optimisation de la détection du point d'attouchement d'une surface tactile capacitive.

On connaît d'après la demande de brevet français FR-A-2 732 135 (ou la demande de brevet européen EP-A-0 733 990) une surface tactile capacitive se présentant sous la forme d'une dalle de verre carrée ou rectangulaire recouverte d'une couche transparente conductrice (en général en ITO, c'est-à-dire de l'oxyde d'étain et d'indium), l'ensemble étant revêtu d'une couche anti-reflets jouant également le rôle d'isolant diélectrique. La couche conductrice est uniforme et est alimentée en énergie haute fréquence alternativement en chacun de ses coins, via une capacité de référence, le coin opposé étant relié à la masse et les deux autres coins étant "en l'air",

Il est possible de déterminer avec une précision correcte le point d'attouchement de cette surface tactile connue, mais dans certains cas d'utilisation, dans des conditions défavorables (par exemple lorsque la surface est embuée, si l'utilisateur porte des gants ou lorsque la surface de contact entre le doigt et la dalle est grande et/ou de forme irrégulière, ...), la détermination du point d'attouchement désiré peut être erronée.

La présente invention a pour but un procédé permettant de déterminer avec la précision la plus élevée possible, pour une surface tactile du type précité, le point d'attouchement par l'utilisateur, même dans les conditions les plus défavorables.

Le procédé conforme à l'invention est définie à la revendication 1.

La présente invention sera mieux comprise à la lecture de la description détaillée d'un mode de réalisation, pris à titre d'exemple non limitatif et illustré par le dessin annexé, sur lequel :

- la figure 1, est une vue de face d'une plaque tactile capacitive telle qu'utilisée par l'invention,
- les figures 2 et 3 sont respectivement une surface gauche représentant un relevé d'équipotentielles conformément à l'invention, et sa projection sur un plan,
- la figure 4 est un organigramme des étapes du procédé de l'invention, et
- la figure 5 est une vue partielle de la plaque de la figure 1, servant à expliquer l'étape d'interpolation conforme à l'invention.

Le procédé de l'invention est mis en oeuvre sur une surface tactile telle que celle décrite dans la demande de brevet français précitée FR-A 2 732 135. Par conséquent, on se reportera à cette demande de brevet pour ce qui est des détails de réalisation de la dalle de verre métallisée et de ses circuits d'alimentation et de traitement de signal. Le présent procédé a pour but l'optimisation de la détermination du point d'attouchement de la plaque constituant cette surface tactile. Cette optimisation permet, en particulier, de déterminer de la façon la plus précise possible le point de la surface que l'utilisateur désigne, surtout lorsqu'il n'utilise pas pour ce faire une pointe, mais appuie plus ou moins fort le plat du doigt sur la surface, même si ses mains sont gantées et si la surface est embuée ou humide. On comprendra facilement que dans de telles conditions la surface de contact entre le doigt de l'utilisateur et la dalle de verre peut être variable dans de grandes proportions et que sa forme peut être très irrégulière. Par conséquent, la capacité rapportée par le doigt de l'utilisateur peut être également variable dans de grandes proportions.

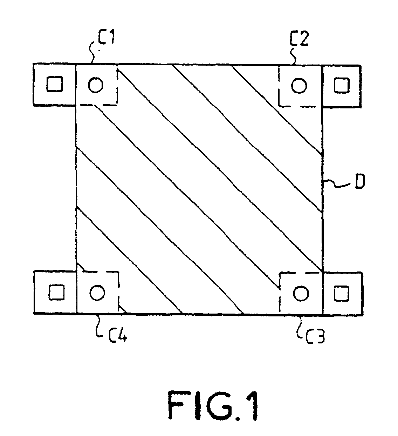

Soient C1 à C4 les quatre coins de la dalle D représentée à la figure 1, qui sont alternativement alimentés en énergie haute fréquence de la façon décrite dans la susdite demande de brevet français. On définit comme sensibilité relative à un coin donné de la dalle la différence entre le signal de sortie de la dalle (tel que recueilli par le circuit de traitement de signal relié alternativement à chacun des coins de la dalle) avec et sans appui du doigt de l'utilisateur, Soient S1 à S4 les sensibilités relatives aux coins C1 à C4, respectivement.

La sensibilité, en général, dépend, pour une position géographique donnée, en n'importe quel endroit de la dalle (dans sa zone utile, bien entendu), de la valeur de la capacité Ch rapportée par l'utilisateur, cette capacité dépendant elle-même de la nature de l'appui (par exemple avec ou sans gants, appui plus ou moins fort, taux d'humidité ambiante, ). La sensibilité est également fonction de la résistance de la couche métallique de la dalle, et plus précisément de la résistance $R_{t1}$ entre le coin alimenté et le point d'attouchement, et de la résistance $R_{t2}$ entre le point d'attouchement et le coin opposé, qui est relié à la masse. Ces deux valeurs $R_{t1}$ et $R_{t2}$ sont caractéristiques de la localisation du point d'attouchement.

Lorsque la capacité rapportée par l'utilisateur peut varier dans de larges proportions, la sensibilité de la dalle, qui est proportionnelle à cette capacité rapportée ($S=k.C_h$), varie également dans de larges proportions, et agit défavorablement sur la qualité de la détection du signal de sortie de la dalle, donc sur la précision de la localisation du point d'attouchement. La présente invention vise l'élimination de ce facteur d'influence pour améliorer la précision de détection.

Considérons les sensibilités relatives à une même diagonale de la dalle, par exemple S1 et S3. On peut écrire :

$$S1 = k.\ f(R_{t1}, R_{t2}) \quad S_3 = k.\ f(R_{t2}, R_{t1}).$$

Le facteur k est représentatif de la capacité rapportée par l'utilisateur. Il est donc invariant pour un même appui (appui dans les mêmes conditions sur la dalle). Or, on peut considérer que du fait que la connexion des quatre coins de la dalle à la source de tension haute fréquence se fait électroniquement très rapidement (en moins d'une milliseconde, par exemple), les conditions d'appui sur la dalle n'ont pas le temps de varier entre les mesures de S1 et S3. Le facteur k peut être donc considéré comme invariant, et peut être éliminé des relations entre S1 et S3 par factorisation et division. On définit ainsi ledit paramètre ou coefficient Kpos, qui est le coefficient de position associé à un appui sur un point quelconque situé sur la diagonale considérée. Dans le cas de la diagonale S1 - S3, on a :

$$Kpos = \frac{S1}{S1 + S3}$$

Grâce à la connaissance de Kpos, on peut localiser la position de l'appui sur la diagonale C1-C3. Il suffit d'associer à chaque valeur de Kpos une position sur cette diagonale C1-C3. Bien entendu, il en est de même pour la diagonale C2-C4.

Pour déterminer la position de l'appui hors d'une diagonale, il faut connaître les lignes équipotentielles (définies ci-dessous) donnant la même valeur de kpos. En procédant de la même façon lors de l'alimentation des coins relatifs à l'autre diagonale, on détermine une autre valeur de kpos et une autre série de lignes équipotentielles. L'endroit d'appui hors des diagonales est déterminé au croisement des deux lignes équipotentielles correspondant aux deux kpos relatifs à l'alimentation des deux diagonales de la surface tactile. Bien entendu, cette détermination ne peut se faire qu'après au moins un cycle complet d'alimentation des quatre coins C1 à C4 de la surface tactile. Pour améliorer la précision de mesure, il est préférable de réaliser plusieurs cycles, et d'effectuer la moyenne des résultats obtenus en éliminant, le cas échéant, ceux situés en dehors d'une fourchette déterminée.

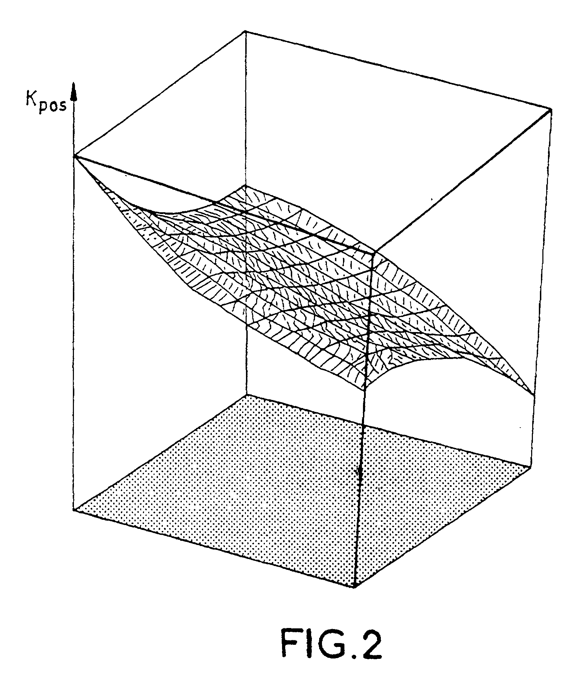

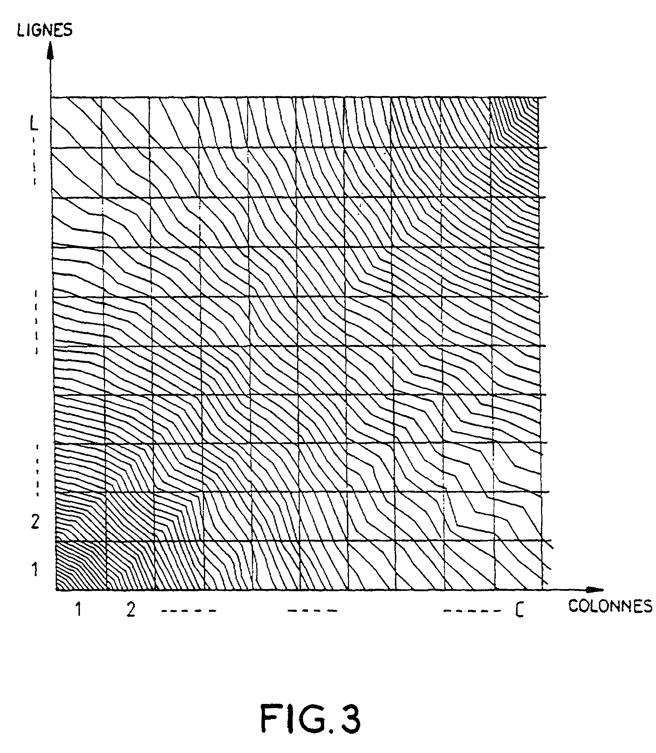

On dénomme ligne équipotentielle une courbe reliant tous les points auxquels correspond un même coefficient de position Kpos. Pour relever ces lignes équipotentielles, on divise la surface de la dalle en un damier comportant un certain nombre de lignes et de colonnes. On effectue ensuite la mesure des coefficients de position pour chacune des zones ainsi discrétisées, pour les deux diagonales. Le nombre de lignes et de colonnes dépend de la résolution recherchée pour la détermination du lieu d'appui. On a représenté en figure 2 un exemple de tels relevés, pour l'une des diagonales. L'ensemble de courbes obtenues forme une surface gauche (non plane), Cet ensemble de courbes peut être projeté verticalement sur un plan. On a représenté en figure 3 les courbes obtenues après projection. On constate, en particulier, une décroissance (ou une croissance, suivant le sens) continue d'un coin au coin opposé, c'est-à-dire que les courbes ne se coupent pas, ce qui signifie qu'il ne peut y avoir d'ambiguïtés dans la détermination du lieu d'appui à partir de la mesure du coefficient de position : à une valeur donnée de Kpos1 correspond une équipotentielle et une seule pour une alimentation des coins C1 et C3. De même, à une valeur donnée de kpos2 correspond une seule équipotentielle pour une alimentation des coins C2 et C4. Le point d'appui est donc situé à l'intersection de ces deux équipotentielles.

Une des caractéristiques avantageuses de la surface tactile utilisée pour la mise en oeuvre du procédé de la présente invention est de permettre la validation de l'appui de l'opérateur sur la surface. En effet, la plaque de verre est reliée en ses quatre coins à son support par des lames électriquement conductrices sur lesquelles sont fixées des jauges de contraintes. Ces jauges de contraintes sont reliées à un circuit de traitement qui produit un signal de validation dès qu'une pression déterminée est exercée sur la plaque, Tant qu'aucune pression n'est exercée, on stocke la valeur de la tension de sortie recueillie sur chacun des quatre coins de la surface. Ces différentes valeurs sont moyennées et stockées sur une période suffisamment longue au fur et à mesure dans une mémoire à condition qu'elles se situent dans une fourchette déterminée. Ainsi, on effectue constamment un rafraîchissement du contenu de la mémoire, ce qui permet d'éliminer l'influence de la dérive des caractéristiques de la surface tactile, dérive qui est en particulier fonction de la température, et aussi de l'hygrométrie. Ainsi, on obtient quatre valeurs de référence au repos, qui permettent de calculer les sensibilités correspondantes.

Lorsque le circuit de traitement des signaux des jauges de contraintes détecte une variation suffisamment importante de leurs signaux, correspondant à un appui sur la surface tactile, il commande l'acquisition des tensions de sortie des quatre coins de la surface, et on calcule la différence entre ces tensions de sortie et lesdites valeurs mémorisées pour en déduire les différentes sensibilités S1 à S4. A partir des valeurs de sensibilités ainsi calculées, on déduit les valeurs de Kpos1 (sur la diagonale C1-C3) et Kpos2 (sur la diagonale C2-C4).

Un point d'appui quelconque sur la plaque, de coordonnées (i, j), est caractérisé par un couple de valeurs {Kpos1 (i, j), Kpos2 (i, j)}. Si le point considéré est le centre d'une quelconque des zones élémentaires définies sur la plaque (voir figure 3), en relevant les couples de valeurs relatifs aux centres de toutes les zones de la plaque, on obtient un tableau de caractérisation de cette plaque. Ce tableau contient L.C tels couples, L étant le nombre de lignes de zones et C le nombre de colonnes de zones de la plaque. Bien entendu, pour une claque donnée, plus L et C sont grands, plus les zones seront petites et meilleure sera la résolution de désignation d'un point d'appui, car, quel que soit le point d'appui à l'intérieur d'une zone ainsi définie, le point d'appui mesuré sera supposé être le centre de la zone. Ceci est particulièrement valable si l'appui est pratiquement ponctuel (par exemple à l'aide d'une pointe). Si la surface d'appui recouvre plusieurs zones (appui avec le plat du doigt), la localisation se fait par minimisation également, la zone ainsi localisée représentant par exemple le centre ou le barycentre de la surface d'appui entre les zones recouvertes, comme décrit ci-dessous.

Le tableau de caractérisation, généralement relevé lors de la fabrication de la surface tactile, peut aussi bien être théorique si la couche d' ITO est homogène et si les conditions de mesure sont idéales. Sinon, on procède à une phase de relevés point par point pour obtenir les valeurs vraies de Kpos.

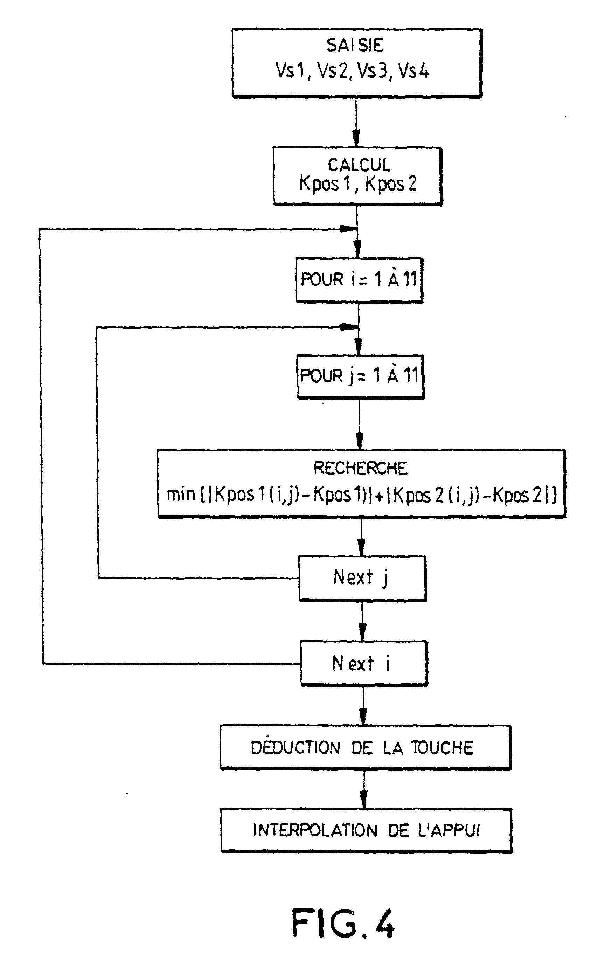

Comme illustrée à la figure 4, à la suite de cette étape de caractérisation, après avoir mémorisé tous les couples de valeurs de Kpos, on peut localiser un appui en un point quelconque de la plaque en calculant les valeurs correspondantes Kpos1 et Kpos2 (d'après les mesures des tensions de sortie recueillies en chacun des quatre coins de la plaque, juste avant appui et juste après, ce qui donne les sensibilités correspondantes, et donc le Kpos1 et Kpos2 ainsi obtenues), on recherche dans ledit tableau de caractérisation de la plaque le couple de valeurs de Kpos se rapprochant le plus du couple de valeurs que l'on vient d'obtenir, ce qui revient à minimiser la différence entre le couple de valeurs obtenues et les différents couples mémorisés dans le tableau. On effectue l'opération suivante, lors du balayage de ce tableau :

$$min \{|Kpos1 (i, j) - Kpos1| + |Kpos2 (i, j) - Kpos2|\}$$

formule dans laquelle Kpos1 (i, il et Kpos2 (i, j) sont les valeurs rencontrées dans ledit tableau lors de son balayage, tandis que Kpos1 et Kpos2 sont les valeurs calculées d'après les mesures effectuées lors de l'attouchement de la plaque.

Une résolution égale à une zone (telle que définie ci-dessus) peut se révéler insuffisante. On pourrait envisager d'augmenter cette résolution en augmentant le nombre de lignes et de colonnes de zones de la plaque, mais cela augmenterait de façon prohibitive la taille de ladite matrice de correction (dans laquelle sont mémorisées les valeurs actualisées des tensions de sortie des coins de la plaque tant qu'il n'y a pas d'appui sur cette plaque). Pour éviter cela, une caractéristique avantageuse de l'invention prévoit d'effectuer une interpolation au voisinage de la zone que l'on vient de déterminer à la suite de l'opération de minimisation. A cette fin, on effectue une interpolation au voisinage de la zone déterminée à la suite de la minimisation.

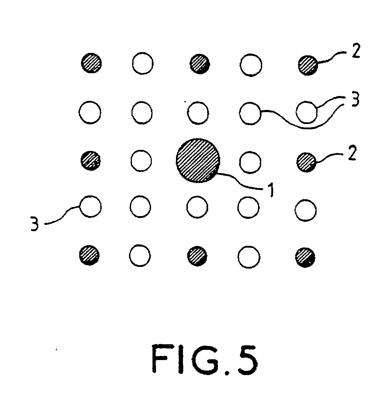

On a représenté en figure 5 une partie de la surface de la plaque, sur laquelle on a représenté par un grand point noir 1 la position d'appui déterminée après minimisation, et par des petits points noirs les huit positions voisines. Dans la portion de surface P délimitée par ces huit positions voisines 2, on calcule par interpolation (linéaire par exemple) les coefficients Kpos1 et Kpos2 correspondant aux positions intermédiaires 3, représentées par des cercles vides. Ces positions intermédiaires sont situées sur des lignes et des colonnes équidistantes des lignes L et colonnes C telles que déterminées de la façon exposée ci-dessus, le pas de ces positions intermédiaires étant égal à la moitié du pas des positions 1 et 2. A partir de la connaissance des coefficients de la position 1 et des positions 2 et 3, on effectue une recherche de position selon le procédé de minimisation exposé ci-dessus, limitée à la portion de surface P. De cette façon, on double la résolution de détermination de point d'appui aussi bien dans la direction des lignes que dans celle des colonnes. Il est même possible de réitérer cette interpolation plusieurs fois de suite afin d'augmenter davantage la résolution, si l'uniformité du dépôt de matériau électriquement conducteur (ITO) de la plaque et la précision de mesure le permettent.

Le procédé de l'invention permet également de détecter l'usure, et en particulier une usure irrégulière du dépôt d'ITO. A cet effet, on mémorise les valeurs initiales des différentes sensibilités pour toutes les zones des L lignes et C colonnes de la plaque, et on leur compare régulièrement les valeurs mesurées. Selon une caractéristique avantageuse de l'invention, on alimente à chaque fois deux coins opposés de la dalle D à travers une résistance insérée en série entre la masse et le coin opposé à celui alimenté en tension HF (comme indiqué par exemple dans ladite demande de brevet français n° 95 03501). Ainsi, lorsque le point d'attouchement est tout proche d'un coin, le signal recueilli par ledit circuit de traitement n'est pas nul, et le coefficient de position ne peut être ni nul ni égal à 1, mais doit être compris dans une fourchette de valeurs, elle-même comprise entre 0 et 1. Cette fourchette de valeurs peut être dénommée domaine de vraisemblance et est relevée pour un dispositif neuf et un bon état de fonctionnement. Par conséquent, si le circuit de traitement détermine un coefficient de position en-dehors de ce domaine de vraisemblance, on peut conclure à une panne (telle qu'une coupure de la couche métallisée) ou à une usure excessive de la couche métallisée.

La surface tactile à laquelle s'applique le procédé de l'invention peut également être utilisée en liaison avec un microprocesseur en tant que dispositif de commande des déplacements d'un curseur (dispositif du genre dit "Touch Pad").

**Revendications**

1. Procédé d'optimisation de la détection du point d'attouchement d'une surface tactile capacitive rectangulaire (D), selon lequel la couche conductrice est alimentée en énergie haute fréquence successivement en chacun de ses coins (C1 à C4), via une capacité de référence, le coin opposé au coin alimenté en énergie étant relié à la masse et les deux autres coins étant "en l'air", caractérisé en ce qu'il comporte une première étape qui consiste à déterminer le long de chacune des diagonales (C1-C3, C2-C4) de la surface tactile, pour un nombre de points correspondant à la résolution recherchée, les valeurs d'un paramètre (Kpos 1, kpos2) qui est fonction des deux tensions de sortie obtenues en alimentant successivement chacun des coins auxquels aboutit la diagonale considérée et aussi fonction de la position du point d'attouchement sur la diagonale considérée, ledit paramètre étant indépendant de la valeur de la capacité (Ch) rapportée par l'utilisateur au point d'attouchement, puis à déterminer, pour des points répartis sur toute la surface de la dalle, les valeurs dudit paramètre (Kpos1) relatif à l'une (C1-C3) puis les valeurs dudit paramètre (Kpos2) relatif à l'autre (C2-C4) diagonale, à mémoriser les couples de paramètres (Kpos1, Kpos2) en fonction des coordonnées de chacun des points correspondants, et une seconde étape de détermination de la position du point d'attouchement qui consiste, à partir d'un couple mesuré de tensions de sortie après alimentation successive des quatre coins de la surface tactile (D), à déterminer les dits deux paramètres (Kpos1,Kpos2) respectivement associés aux deux diagonales et, à retrouver en mémoire les coordonnées correspondantes et uniques du point d'attouchement à partir de ces deux paramètres.

2. Procédé selon la revendication 1, caractérisé en ce que l'on recherche en mémoire les coordonnées du point d'attouchement par minimisation de la différence entre les paramètres calculés d'après les mesures de tensions de sortie et ceux résidant en mémoire.

3. Procédé selon la revendication 1 ou 2, caractérisé en ce que ledit paramètre (Kpos1 ou Kpos2) de chaque diagonale est déterminé, pour l'alimentation des extrémités de chaque diagonale de la surface, par un rapport S1/(S1 - S3) entre les sensibilités respectives S1 et S3 vues des deux extrémités respectives de la diagonale, la sensibilité étant définie comme la différence entre la tension relevée à l'extrémité considérée en l'absence d'attouchement et celle relevée lors de l'attouchement.

4. Procédé selon la revendication 2, caractérisé en ce que l'on effectue une interpolation des valeurs des deux paramètres (Kpos1,Kpos2) au voisinage de la zone déterminée à la suite de la minimisation afin d'augmenter la résolution de la détection.

5. Procédé selon l'une des revendications précédentes, caractérisé en ce que l'on définit un domaine de vraisemblance pour les paramètres relevés pour un dispositif neuf et en bon état de fonctionnement, et que l'on compare en cours de fonctionnement du dispositif les valeurs relevées des paramètres au domaine de vraisemblance, les valeurs situées en-dehors du domaine correspondant à une panne ou à une usure excessive du dispositif.

**Patentansprüche**

1. Verfahren zur Optimierung der Erfassung des Berührungspunkts einer rechtwinkligen, kapazitiven Tastoberfläche (D), bei dem die leitende Schicht nacheinander an jeder ihrer Ecken (C1 bis C4) über eine Referenzkapazität mit hochfrequenter Energie versorgt wird, wobei die Ecke, die der mit Energie versorgten Ecke gegenüberliegt, mit Masse verbunden ist und die beiden anderen Ecken "freiliegen", dadurch gekennzeichnet, daß mit einem ersten Schritt längs jeder Diagonalen (C1-C3, C2-C4) der Tastoberfläche für eine der gesuchten Auflösung entsprechende Anzahl von Punkten die Werte eines Parameters (Kposl, Kpos2) bestimmt werden, der von den beiden Ausgangsspannungen, die erhalten werden, wenn nacheinander jede der Ecken gespeist wird, auf die die betreffende Diagonale trifft, und außerdem von der Position des Berührungspunkts auf der betrachteten Diagonale abhängt, wobei der Parameter vom Wert der Kapazität (Ch), die dem Berührungspunkt vom Anwender verliehen wird, unabhängig ist, und dann für die auf der gesamten Oberfläche der Platte verteilten Punkte die Werte des Parameters (Kpos1) für eine Diagonale (C1-C3) und anschließend die Werte des Parameters (Kpos2) für die andere Diagonale (C2-C4) bestimmt werden und die Parameterpaare (Kpos1, Kpos2) in Abhängigkeit von den Koordinaten jedes der entsprechenden Punkte gespeichert werden, sowie mit einem zweiten Schritt zum Bestimmen der Position des Berührungspunkts anhand eines gemessenen Paars von Ausgangsspannungen nach der aufeinanderfolgenden Speisung der vier Ecken der Tastoberfläche (D) die beiden Parameter (Kpos1, Kpos2) bestimmt werden, die den beiden Diagonalen zugeordnet sind, und aus dem Speicher die entsprechenden und eindeutigen Koordinaten des Berührungspunkts anhand dieser beiden Parameter wiedergewonnen werden.

2. Verfahren nach Anspruch 1, dadurch gekennzeichnet, daß im Speicher die Koordinaten des Berührungspunkts durch Minimierung der Differenz zwischen den anhand der Meßwerte der Ausgangsspannungen berechneten Parametern und jenen, die im Speicher abgelegt sind, gesucht werden.

3. Verfahren nach Anspruch 1 oder 2, dadurch gekennzeichnet, daß der Parameter (Kpos1 oder Kpos2) jeder Diagonale bei einer Speisung der Enden jeder Diagonale der Fläche durch ein Verhältnis S1/(S1 - S3) zwischen den jeweiligen betrachteten Empfindlichkeiten S1 und S3 der beiden jeweiligen Enden der Diagonale bestimmt wird, wobei die Empfindlichkeit als Differenz zwischen der am betrachteten Ende bei fehlender Berührung abgegriffenen Spannung und jener, die bei Berührung abgegriffen wird, definiert ist.

**4.** Verfahren nach Anspruch 2, dadurch gekennzeichnet, daß eine Interpolation der Werte der beiden Parameter (Kpos1, Kpos2) in der Umgebung der bestimmten Zone nach der Minimierung ausgeführt wird, um die Erfassungsauflösung zu erhöhen.

**5.** Verfahren nach einem der vorhergehenden Ansprüche, dadurch gekennzeichnet, daß für die Parameter, die für eine neue und in gutem Funktionszustand befindliche Vorrichtung abgegriffen werden, ein Wahrscheinlichkeitsbereich definiert wird und daß während des Betriebs der Vorrichtung die abgegriffenen Werte der Parameter mit dem Wahrscheinlichkeitsbereich verglichen werden, wobei die außerhalb des Bereichs liegenden Werte einem Ausfall oder einem übermäßigen Verschleiß der Vorrichtung entsprechen.

## Claims

**1.** Process for optimizing the detection of the point of touching of a rectangular capacitive tactile surface (D), according to which the conducting layer is supplied with high-frequency energy successively at each of its corners (C1 to C4), via a reference capacitance, the corner opposite the corner supplied with energy being earthed and the other two corners being "idle", characterized in that it includes a first step which consists in determining along each of the diagonals (C1-C3, C2-C4) of the tactile surface, for a number of points corresponding to the sought-after resolution, the values of a parameter (Kpos1, Kpos2) which is dependent on the two output voltages obtained by supplying successively each of the corners at which the relevant diagonal terminates, and also dependent on the position of the point of touching on the relevant diagonal, the said parameter being independent of the value of the capacitance (Ch) added by the user at the point of touching, then in determining, for points distributed over the whole surface of the slab, the values of the said parameter (Kposl) relating to one (C1-C3) then the values of the said parameter (Kpos2) relating to the other (C2-C4) diagonal, in storing the pairs of parameters (Kpos1, Kpos2) as a function of the coordinates of each of the corresponding points, and a second step of determining the position of the point of touching which consists, on the basis of a measured pair of output voltages after successive supplying of the four corners of the tactile surface (D), in determining the said two parameters (Kpos1, Kpos2) respectively associated with the two diagonals and in retrieving from memory the corresponding and unique coordinates of the point of touching on the basis of these two parameters.

**2.** Process according to Claim 1, characterized in that the coordinates of the point of touching are searched for in the memory by minimizing the difference between the parameters calculated in accordance with the measurements of output voltages and those residing in memory.

**3.** Process according to Claim 1 or 2, characterized in that the said parameter (Kpos1 or Kpos2) of each diagonal is determined, for the supply to the ends of each diagonal of the surface, by a ratio (S1/(S1 + S3)) between the respective sensitivities S1 and S3 viewed from the two respective ends of the diagonal, the sensitivity being defined as the difference between the voltage charted at the relevant end in the absence of touching and that charted during touching.

**4.** Process according to Claim 2, characterized in that an interpolation of the values of the two parameters ((Kpos1, Kpos2) is performed in the neighbourhood of the zone determined following minimization, in order to increase the resolution of the detection.

**5.** Process according to one of the preceding claims, characterized in that a likelihood domain is defined for the parameters charted for a new device operating properly, and the charted values of the parameters are compared with the likelihood domain during operation of the device, the values lying outside the domain corresponding to a fault or to excessive wear of the device.

FIG.1

FIG.2

FIG.3

FIG.4

FIG.5